Europäisches Patentamt

European Patent Office

Office européen des brevets

(19)

(11) **EP 1 566 834 A1**

(12) **EUROPEAN PATENT APPLICATION**
published in accordance with Art. 158(3) EPC

(43) Date of publication:
**24.08.2005 Bulletin 2005/34**

(51) Int Cl.⁷: **H01L 21/268**, H01L 21/20

(21) Application number: **03758890.2**

(22) Date of filing: **24.10.2003**

(86) International application number:
**PCT/JP2003/013647**

(87) International publication number:
**WO 2004/042806 (21.05.2004 Gazette 2004/21)**

(84) Designated Contracting States:
**AT BE BG CH CY CZ DE DK EE ES FI FR GB GR HU IE IT LI LU MC NL PT RO SE SI SK TR**

(30) Priority: **05.11.2002 JP 2002321705**

(71) Applicant: **SONY CORPORATION Tokyo 141-0001 (JP)**

(72) Inventors:
• **Hotta, Shin c/o Sony Corporation Tokyo 141-0001 (JP)**

• **Tsukihara, Koichi c/o Sony Corporation Tokyo 141-0001 (JP)**
• **Ohshima, Akifumi c/o Sony Corporation Tokyo 141-0001 (JP)**
• **Mizusawa, Takashi c/o Sony Corporation Tokyo 141-0001 (JP)**
• **Abe, Masaaki c/o Sony Corporation Tokyo 141-0001 (JP)**

(74) Representative: **Thévenet, Jean-Bruno et al Cabinet Beau de Loménie 158, rue de l'Université 75340 Paris Cédex 07 (FR)**

(54) **LIGHT IRRADIATOR AND LIGHT IRRADIATING METHOD**

(57) A light irradiator used as a laser annealing apparatus is provided which includes a controller (9) which controls a solid-state laser (4) to make pulse-on operation by detecting that the angle of rotation of a rotating shaft (7a) becomes $+\beta$ after the rotating direction of the rotating shaft (7a) changes from clockwise to counterclockwise and then make pulse-off operation by detecting that the angle of rotation become $-\beta$, while controlling the solid-state laser (4) to make the pulse-on operation by detecting that the angle of rotation becomes $-\beta$ after the rotating direction changes from counterclockwise to clockwise and then make the pulse-off operation by detecting that the angle of rotation becomes $+\beta$. Further, the controller (9) controls a moving stage (3) to move at a constant velocity in a constant-velocity moving direction, and move over a predetermined distance in a predetermined-distance moving direction after a to-be-annealed object (2) is irradiated with the light beam on a range from one end thereof to the other end in the constant-velocity moving direction, thereby irradiating the whole surface of the to-be-irradiated object (2) with a uniform energy.

FIG.1

**Description**

Technical Field

The present invention relates to a light irradiating apparatus and method, usefully applied in a laser annealing apparatus or the like used in manufacture of a polysilicon thin-film transistor, for example.

This application claims the priority of the Japanese Patent Application No. 2002-321705 filed on November 5, 2002, the entirety of which is incorporated by reference herein.

Background Art

A laser annealing apparatus used in manufacture of a semiconductor element or the like uses, as a laser source, an excimer laser that can emit a light beam having a high energy.

The excimer laser is filled with a gas which however will be degraded by a chemical reaction and the like as the time elapses. Therefore, the laser annealing apparatus using the excimer laser needs complicated maintenance such as daily exchange of the gas or the like and thus its running cost will be high. Also, since the laser annealing apparatus has to be kept out of operation during the gas exchange, the productive efficiency will be lower for the down time. Moreover, the excimer laser cannot emit any light beam stable in energy. For example, after the gas is exchanged, the excimer laser will emit a light beam higher in energy. Therefore, with a laser annealing apparatus adopting an excimer laser as the laser source, it is difficult to uniformly anneal an object to be annealed, resulting in a lower yield.

On this account, it has been proposed to use a solid-state laser capable of emitting a light beam stable in energy and which needs not any complicated maintenance such as exchange of the gas or the like.

The solid-state laser is smaller in amount of energy per pulse than the excimer laser but can generate light beam pulses at a higher pulse rate. For example, the excimer laser emits a light beam of about 1 joule (J) in energy per pulse and generates light beam pulses at a rate of about 200 Hz, and thus the laser energy is about 200 W per second. On the other hand, the solid-state laser emits a light beam having an energy of about 1 mJ per pulse and generates light beam pulses at a rate of about 10 kHz, and thus the laser energy is about 10 W per second. Therefore, the solid-state laser emits a light beam having an energy equal to 1/20 of the light beam energy emitted by the excimer laser. That is, to irradiate a-Si with a light beam having the same energy as that one excimer laser will provide, twenty solid-state lasers have to be used as a laser source.

The energy per pulse of the solid-state laser is low as above. For example, when twenty solid-state lasers are used to emit a light beam under the same conditions as above, the light beam will have an energy of about 20 mJ per pulse, which is about 1/50 of that the excimer laser will provide. For a satisfactory annealing of a-Si, the latter should be irradiated with a light beam having an energy density having a higher value than a certain one. Therefore, in case a solid-state laser is used as a laser source, the section, perpendicular to the optical axis, of a laser beam emitted from the solid-state laser, should be smaller in area than that which will be when the excimer laser is used.

For shaping a light beam emitted from the solid-state laser into a line beam having a uniform energy density having a value larger than a certain one, the aspect ratio of the section, perpendicular to the optical axis, of the light beam has to be extremely large. In a beam shaping optical system for such a very large aspect ratio of the section, perpendicular to the optical axis, of the light beam, there should be used many optical elements which are very small and high in precision. That is, the beam shaping optical system will be complicated in structure and utilize the light energy with not a high efficiency. For the aforementioned reasons, it is very difficult to shape a light beam emitted from the solid-state laser into a line beam having a uniform energy density having a larger value than a certain one.

Therefore, in case a solid-state laser is used as a laser source, it is desirable that a light beam emitted from the solid-state laser is shaped for a smaller aspect ratio of the section thereof perpendicular to the optical axis and an object to be annealed be irradiated with the light beam while the latter is being deflected for thereby scanning a light beam spot on the object in the two-dimensional direction.

Also, in the solid-state laser, light beam pulses are generated at a repetition rate about 50 times higher than that which will be with the excimer laser. Therefore, in case a solid-state laser is adopted as a laser source, the moving stage has to be moved at a velocity about 50 times higher than that which will be with the excimer laser as a laser source for no increased number of times of light beam irradiation to the to-be-annealed object. However, if the moving stage is moved at such a velocity about 50 times higher than that with the excimer laser as a laser source, the moving velocity will be extremely high, possibly resulting in a problem such as abrasion or the like.

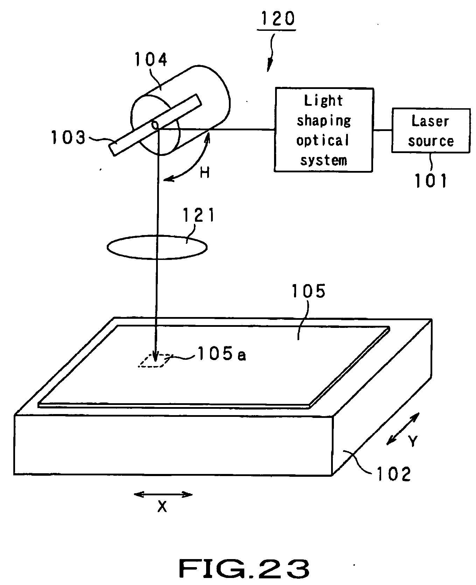

As a laser annealing apparatus to solve the aforementioned problems, there has been proposed a laser annealing apparatus constructed as shown in FIG. 23.

The laser annealing apparatus, generally indicated with a reference numeral 120, uses a solid-state laser as a laser source 101 as shown in FIG. 23. It further includes a moving stage 102 that moves in a direction parallel with the main surface of an object to be annealed 105, namely, in the direction of arrow Y in FIG. 23, and a reflecting mirror 103 and galvanometer 104, which move a spot 105a in a direction of arrow X perpendicular to the direction of arrow Y, namely, in a direction which is also parallel with the main surface of the to-be-annealed object 105.

In the laser annealing apparatus 120 shown in FIG. 23, the moving stage 102 and galvanometer 104 are driven in a step-and-repeat manner which will be described below. First, the galvanometer 104 is driven with the moving stage 102 being kept still to move the reflecting mirror 103 from one end to the other end in the direction of arrow X, and the moving stage 102 is moved in the direction of arrow Y with the galvanometer 104 being kept still. These steps of movement are made alternately.

In the above-mentioned step-and-repeat manner if applied, however, one of the moving stage 102 and galvanometer 104 is made to stand still and then the other is driven, which causes a time loss. That is, the time loss will lead to a considerable reduction of the productivity. Also, the number of times of light beam irradiation to the to-be-annealed object 105 varies from one spot to another unless both the moving stage 102 and galvanometer 104 are driven with a high accuracy of positioning.

Therefore, in the laser annealing apparatus 120, the galvanometer 104 should preferably be driven while the moving stage 102 is being moved at a constant velocity in the direction of arrow Y in FIG. 23 to oscillate the reflecting mirror 103 in the direction of arrow X in FIG. 23, to thereby linearly move the spot 105a on the to-be-annealed object 105 repeatedly in a constant range. At this time, for moving the spot 105a at a constant velocity, the galvanometer 104 is applied with a triangular-wave voltage of a frequency $f_{galvo}$ as given by the following equation (21) to oscillate the reflecting mirror 103 at a constant angular velocity. Since a light beam reflected by the reflecting mirror 103 oscillated at the angular velocity is irradiated to the to-be-annealed object 105 through an fθ lens 121, the spot 105a on the to-be-annealed object 105 is moved at a constant velocity in the direction of arrow X. It should be noted that when the moving stage 102 is moved at a velocity $V_{stage}$ as given by the following equation (22) in the direction of arrow Y, all to-be-annealed objects 105 can be irradiated with the light beam the same number of times.

$$f_{galvo} = (F_{rep} \cdot W_x)/(2D) \qquad (21)$$

$$V_{stage} = (F_{rep} \cdot W_x \cdot W_y)/(nD) \qquad (22)$$

where $F_{rep}$ is a repetition rate at which the laser source generates light beam pulses, $W_x$ is a length of the spot 105a in the direction of arrow X in FIG. 23, D is an amplitude of the center of the spot moving on the to-be-annealed objected 105 when the galvanometer 104 oscillates ideally, and n is a mean number of times of light beam irradiation to the whole surface of the to-be-annealed object 105, the number n being a natural even number. It should be noted that when the number n is an odd one, no uniform irradiation is attained but the mean number of times of irradiation over the region of irradiation will be n.

Note that when the number of times of light beam irradiation is a multiple of 4, the number of times of light beam irradiation to the to-be-annealed object 105 can be made constant even if the galvanometer 104 is applied with a triangular-wave voltage of a frequency $f_{galvo}$ as given by the following equation (23) and at the same time the moving stage 102 is moved at a velocity $V_{stage}$ as given by the following equation (24) in the direction of arrow Y.

$$f_{galvo} = (F_{rep} \cdot W_x)/(4D) \qquad (23)$$

$$V_{stage} = (2 \cdot F_{rep} \cdot W_x \cdot W_y)/(mD) \qquad (24)$$

where m is a mean number of times of light beam irradiation over the main surface of the to-be-annealed object 105, the number m being a multiple of 4.

Even if the galvanometer 104 is applied with a triangular-wave voltage as given by the above equation (22) or (23), however, an inertia will cause the galvanometer 104 to move more slowly when it has come near to a change point of the moving direction of the spot 105a and the spot amplitude to be smaller than D. Therefore, in a place near to the change point of the moving direction of the spot 105a, the area in which a spot 105a and an adjacent spot 105a overlap each other will be larger so that the to-be-annealed object 105 will be irradiated with the light beam an increased number of times.

To prevent the to-be-annealed object 105 from being irradiated with the light beam such an increased number of times in a place near the change point of the moving direction of the spot 105a, it has already been proposed to change the rate at which light beam pulses are generated from the laser source 101 correspondingly to the oscillating rate of the reflecting mirror 103 while changing the moving velocity of the moving stage 102, for example. With the solid-state laser, however, when the pulse rate is so changed, the optical elements provided inside the laser will be different in temperature from each other, the intensity distribution, divergent angle, etc. of the emitted light beam will thus be varied and it be difficult to emit a desired light beam. Also, changing the pulse rate of the light beam emitted from the laser source 101 and moving velocity of the moving stage 102 correspondingly to the oscillation velocity of the galvanometer 104 needs a complicated and high-speed control, resulting in a difficulty in designing the laser annealing apparatus 120, for example.

Further, the diameter of the fθ lens 121 used in the laser annealing apparatus 120 will limit the range of light beam irradiation with the galvanometer 104 being oscillated. That is, the range of light beam irradiation with the galvanometer 104 being oscillated while the moving stage 102 is moved at a constant velocity will be long in the direction of arrow Y in FIG. 23 and the width W in the direction of arrow X in FIG. 23 will be limited by the $f\theta$ lens 121. However, it is difficult to design and produce a large-diameter, high-precision $f\theta$ lens. Therefore, in the laser annealing apparatus 120, when it is necessary to irradiate a light beam to a range in which the width W in the direction of arrow X in FIG. 23 is larger than a one limited by the $f\theta$ lens 121, the light beam irradiation is followed by a movement of the moving stage 102 over the width W in the direction of arrow X in FIG. 23, namely, the light beam irradiation and moving-stage movement are done alternately.

Since the movement of the moving stage 102 in the direction of arrow X in FIG. 23 is limited in accuracy, the moving stage 102 cannot be moved precisely over the width W in the direction of arrow X as the case may be. When the moving stage 102 has moved over a distance larger than the width W in the direction of arrow X in FIG. 23, some region on the to-be-annealed object 105 will not be irradiated with the light beam. When the moving stage 102 has moved over a distance smaller than the width W in the direction of arrow X in FIG. 23, some region on the to-be-annealed object 105 will be irradiated with the light beam doubly the normal number of times. That is, when the moving stage 102 cannot be moved precisely over the width W in the direction of arrow X in FIG. 23, the to-be-annealed object 105 can hardly be irradiated uniformly with the light beam.

Moreover, the moving velocity of the moving stage 102, if moved at a velocity $V_{stage}$ as given by the above-mentioned equation (22) or (24) will vary within a range of about $\pm 5$ %. If the moving velocity of the moving stage 102 is thus varied, the range in which a spot 105a and an adjacent one 105a overlap each other will vary and the number of times of light beam irradiation to the to-be-annealed object 105 will vary correspondingly.

Disclosure of the Invention

Accordingly, the present invention has an object to provide an improved and novel light irradiating apparatus and method, capable of overcoming the above-mentioned drawbacks of the related art.

The present invention has another object to provide a light irradiating apparatus and method, capable of irradiating a laser light having a sufficient energy to the whole surface of a to-be-irradiated object uniformly and efficiently even if a laser source adopted therein is a solid-state laser small in energy per pulse and high in pulse rate.

The above object can be attained by providing a light irradiating apparatus including according to the present invention:

a laser source to emit a light beam;
a stage to support a flat to-be-irradiated object;
an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object;
a light beam emission controlling means for controlling the light beam emission from the laser source correspondingly to the angle of deflection of the light beam;
a first controlling means for irradiating the light beam, of which the emission has been controlled by the light beam emission controlling means, to the main surface of the to-be-irradiated object while scanning the light beam in the first direction, and moving the stage in relation to the irradiating means in a second direction perpendicular to the first direction along the main surface of the to-be-irradiated object; and
a second controlling means for controlling the stage, once moved by the first controlling means, to move in relation to the irradiating means in the first direction,
the light beam irradiation controlled by the first controlling means being made to the same to-be-irradiated surface of the to-be-irradiated object in each of a plurality of different positions along the first direction, reached under the control of the second controlling means, and almost all the to-be-irradiated surfaces of the to-be-irradiated object undergoing the light beam irradiation controlled by the first controlling means in each of the different positions.

Also the above object can be attained by providing a light irradiating apparatus including according to the present invention:

a laser source to emit a light beam;
a moving stage which supports a flat to-be-irradiated object and moves the to-be-irradiated object in a direction parallel with the main surface of the to-be-irradiated object;
an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object; and

a light beam emission controlling means for controlling the light beam emission from the laser source correspondingly to the angle of deflection of the light beam.

Also the above object can be attained by providing a light irradiating apparatus including according to the present invention:

a laser source to emit a light beam;

a moving stage to support a flat to-be-irradiated object;

an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object;

a first controlling means for irradiating the light beam, of which the emission has been controlled by a light beam emission controlling means, to the main surface of the to-be-irradiated object while scanning the light beam in the first direction, and moving the stage in relation to the irradiating means in a second direction perpendicular to the first direction along the main surface of the to-be-irradiated object; and

a second controlling means for controlling the stage, once moved by the first controlling means, to move in relation to the irradiating means in the first direction,

the light beam irradiation controlled by the first controlling means being made to the same to-be-irradiated surface of the to-be-irradiated object in each of a plurality of different positions along the first direction, reached under the control of the second controlling means, and almost all the to-be-irradiated surfaces of the to-be-irradiated object undergoing the light beam irradiation controlled by the first controlling means in each of the different positions.

Also the above object can be attained by providing a light irradiating method including, according to the present invention:

a light beam emitting step in which a laser source emits a light beam;

an irradiating step including a deflecting step of deflecting an incident light beam while changing the angle of deflection periodically in a constant range, and in which the light beam emitted from the laser source is guided and irradiated the light beam to the main surface of the to-be-irradiated object while the light beam is being scanned in a first direction along the main surface of the to-be-irradiated object;

a light beam emission controlling step of controlling the light beam emission from the laser source correspondingly to the angle of deflection of the light beam;

a first controlling step of irradiating the light beam, of which the emission has been controlled in the light beam emission controlling step, to the main surface of the to-be-irradiated object while scanning the light beam in the first direction, and moving the to-be-irradiated object in relation to the light beam, having been irradiated to the main surface of the to-be-irradiated object in the irradiating step, in a second direction perpendicular to the first direction along the main surface of the to-be-irradiated object; and

a second controlling step of moving the to-be-irradiated object, once moved in the first controlling step, in relation to the light beam irradiated to the main surface in the irradiating step,

the light beam irradiation controlled in the first controlling step being made to the same to-be-irradiated surface of the to-be-irradiated object in each of a plurality of different positions along the first direction, reached in the second controlling step, and almost all the to-be-irradiated surfaces of the to-be-irradiated object undergoing the light beam irradiation controlled in the first controlling step in each of the different positions.

Also the above object can be attained by providing a light irradiating method including according to the present invention:

a light beam emitting step in which a laser source emits a light beam;

a moving step of moving a flat to-be-irradiated object in a direction parallel with the main surface of the to-be-irradiated object;

an irradiating step including a deflecting step of deflecting an incident light beam while changing the angle of deflection periodically in a constant range, and in which the light beam emitted from the laser source is guided and irradiated to the main surface of the to-be-irradiated object while the light beam is being scanned in a first direction along the main surface of the to-be-irradiated object; and

a light beam emission controlling step of controlling the light beam emission from the laser source correspondingly to the angle of deflection of the light beam.

Also the above object can be attained by providing a light irradiating method including according to the present invention:

a light beam emitting step in which a laser source emits a light beam;

an irradiating step including a deflecting step of deflecting an incident light beam while changing the angle of deflection periodically in a constant range, and in which the light beam emitted from the laser source is guided and irradiated to the main surface of the to-be-irradiated object while the light beam is being scanned in a first direction along the main surface of the to-be-irradiated object;

a first controlling step of irradiating the light beam controlled in the light beam emission controlling step to the main surface of the to-be-irradiated object while scanning the light beam in the first direction, and moving the to-be-irradiated object in relation to the light beam irradiated to the main surface of the to-be-irradiated object in the irradiating step in a second direction perpendicular to the first direction along the main surface of the to-be-irradiated object; and

a second controlling step of moving the to-be-irradiated object, once moved in the first controlling step, in relation to the light beam irradiated to the main surface of the to-be-irradiated object in the irradiating step,

the light beam irradiation controlled in the first controlling step being made to the same to-be-irradiated surface of the to-be-irradiated object in each of a plurality of different positions along the first direction, reached in the second controlling step, and almost all the to-be-irradiated surfaces of the to-be-irradiated object undergoing the light beam irradiation controlled in the first controlling step in each of the different positions.

These objects and other objects, features and advantages of the present invention will become more apparent from the following detailed description of the best mode for carrying out the present invention when taken in conjunction with the accompanying drawings.

Brief Description of the Drawings

FIG. 1 is a perspective view of the laser annealing apparatus according to the present invention.

FIG. 2 shows the movement of a spot defined on an object to be annealed.

FIG. 3 shows adjacent spots overlapping each other in a predetermined area when the reflecting mirror is oscillated at a constant velocity.

FIG. 4 shows a spot and adjacent spot, not overlapping each other.

FIG. 5 shows that the length of an area, where a spot and adjacent spot overlap each other, in a direction of movement over a predetermined distance is $W_x/2$.

FIG. 6 shows a relation between a triangular-wave voltage applied to the galvanometer and an angle of rotation of the rotating shaft.

FIG. 7 shows a movement of a spot when a light beam is irradiated to a to-be-annealed object under no control of the controller.

FIG. 8 shows a relation between the angles of rotation $\alpha$ and $\beta$.

FIG. 9 shows a movement of a spot when the light beam is irradiated to the to-be-annealed object under the control of the controller.

FIG. 10 shows a movement of a spot when columns are formed.

FIG. 11 shows a movement of a spot when the entire to-be-annealed object is to be annealed.

FIG. 12 is a schematic diagram showing how a light beam is irradiated to the to-be-annealed object when i = 2 and n = 4.

FIG. 13 is also a schematic diagram showing how a light beam is irradiated to the to-be-annealed object when i = 2 and n = 10.

FIG. 14A explains that a light beam will be irradiated to the to-be-annealed object (n + i) times when the area where a column and adjacent column overlap each other is larger than a predetermined area and FIG. 14B explains that a light beam will be irradiated to the to-be-annealed object (n - i) times when the area where a column and adjacent column overlap each other is smaller than the predetermined area.

FIG. 15 shows a relation among angles of rotation $\alpha$, $\beta$ and Y and a relation between the angle of rotation Y of the rotating shaft and number of times of irradiation to the to-be-irradiated object, in which FIG. 15A shows a relation among the angles of rotation $\alpha$, $\beta$ and Y and a relation among $\alpha$, $\beta$ and $\gamma$, and FIGS. 15B and 15C show a relation between the angle of rotation Y of the rotating shaft and number of times of irradiation to the to-be-irradiated object.

FIG. 16 shows once-irradiated regions formed in opposite end portions, respectively, of a region already irradiated with a light beam twice.

FIG. 17A shows that an object to be annealed when i = 2 and n = 4 will be irradiated with a light beam three times when the area where adjacent columns overlap each other is smaller than a predetermined area, and FIG. 17B shows that the object to be annealed when i = 2 and n = 4 will be irradiated with a light beam five times when the area where adjacent columns overlap each other is larger than a predetermined area.

FIG. 18 is a schematic diagram showing that the length of an area, where a spot and adjacent spot overlap each other, in a direction of movement over a predetermined distance is $W_x/3$.

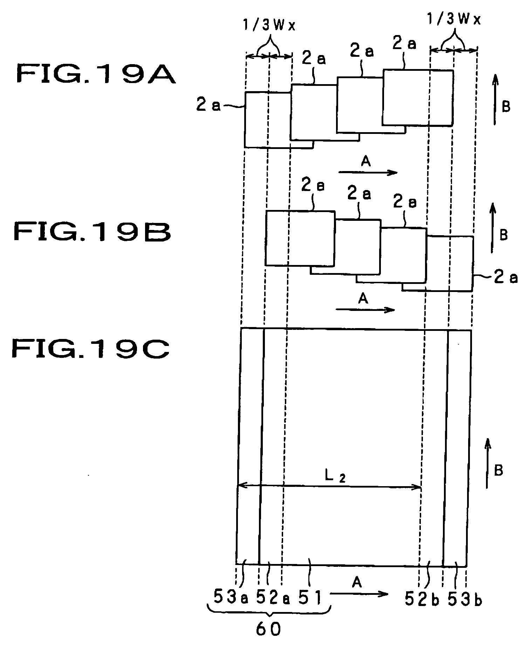

FIG. 19A shows spots moved from one to other end in the direction of movement over a predetermined distance when the length of an area, where a spot and adjacent spot overlap each other, in a direction in which the area is moved over the predetermined distance is $W_x/3$, FIG. 19B shows spots moved from one to other end in the direction of movement over a predetermined distance when the length L of an area, where a spot and adjacent spot overlap each other, in a direction in which the area is moved over the predetermined distance is $W_x/3$, and FIG. 19C shows once-irradiated and twice-irradiated regions formed in opposite end portions, respectively, of a region already irradiated with a light beam three times.

FIG. 20 is a schematic diagram showing how a light beam is irradiated to the to-be-annealed object when n = 5.

FIG. 21 is also a schematic diagram showing how a light beam is irradiated to the to-be-annealed object when n = 7.

FIG. 22A shows that an object to be annealed when n = 5 will be irradiated with a light beam four times when the area where adjacent columns overlap each other is smaller than a predetermined area, and FIG. 22B shows that the object to be annealed under the same conditions as in FIG. 22A will be irradiated with a light beam six times when the area where adjacent columns overlap each other is larger than a predetermined area.

FIG. 23 schematically illustrates the conventional laser annealing apparatus.

Best Mode for Carrying Out the Invention

The present invention will be illustrated and described in detail below concerning an application thereof to a laser annealing apparatus.

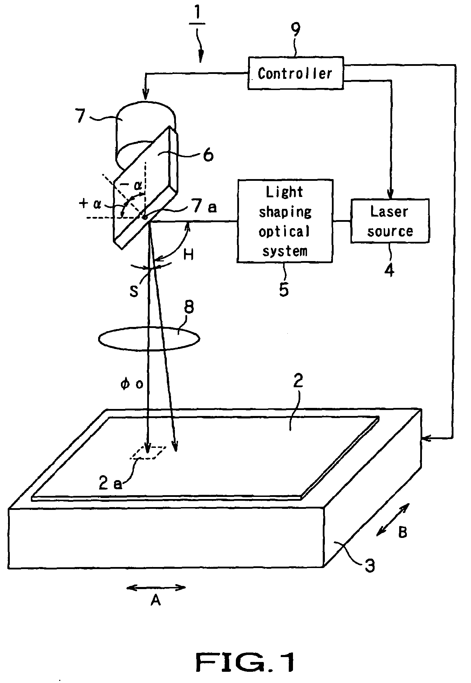

Referring now to FIG. 1, there is schematically illustrated the laser annealing apparatus according to the present invention. The laser annealing apparatus is generally indicated with a reference numeral 1. As shown in FIG. 1, the laser annealing apparatus 1 includes a moving stage 3 provided to support an object to be annealed object 2 and which is movable in a direction parallel with the main surface of the to-be-annealed object 2, a solid-state laser 4 to generate light beam pulses, a light shaping optical system 5 to shape the section perpendicular to the optical axis of the light beam emitted from the solid-state laser 4 and average the energy density of the light beam, a reflecting mirror 6 to deflect the light beam going out from the light shaping optical system 5, a galvanometer 7 to oscillate the reflecting mirror 6 at a constant velocity, an fθ lens 8 which irradiates the light beam deflected by the reflecting mirror 6 to the to-be-annealed object 2, and a controller 9 to control the light beam emission from the solid-state laser 4 correspondingly to the angle of deflection of the light beam deflected by the reflecting mirror 6.

The moving stage 3 supports a flat to-be-annealed object 2 such as an a-Si thin film formed on a glass substrate, for example. The moving stage 3 is moved in two different directions parallel with the main surface of the to-be-annealed object 2 and perpendicular to each other. More particularly, the moving stage 3 is moved stepwise over a predetermined distance in one of the two directions parallel to the main surface of the to-be-annealed object 2 and perpendicular to the each other, the one direction being a direction of arrow A in FIG. 1 (which will be referred to as "direction in which the moving stage is moved over a predetermined distance" or "predetermined-distance moving direction" wherever appropriate hereunder), and also it is moved at a constant velocity in the other of the two directions parallel to the main surface of the to-be-annealed object 2 and perpendicular to the each other, the other direction being a direction of arrow B in FIG. 1 (which will be referred to as "direction in which the moving stage is moved at a constant velocity" or "constant-velocity moving direction" wherever appropriate hereunder). In this embodiment, the moving stage 3 is provided with a screw-feeding pulse motor for moving the moving stage 3 in the predetermined-distance moving distance, and an air-sliding linear motor for moving the moving stage 3 in the constant-velocity moving direction.

The solid-state laser 4 emits a laser light. The solid-state laser 4 uses, as a base material, a transparent material such as a crystal, glass or the like except for a semiconductor, in which a rare earth ion, transition metal ion or the like is doped. When excited by light, the solid-state laser 4 emits a laser beam. The solid-state laser used in this embodiment includes Nd:YAG (yttrium aluminum garnet) laser, Nd:YVO laser, Nd:YLF (yttrium lithium fluoride) laser, Ti:sapphire laser or a harmonic one of these lasers.

The solid-state laser 4 can turn on and off the generation of light beam pulses. In this embodiment, the solid-state laser 4 is provided with a Q switch. Using the factor that when the Q switch is on, little induced emission will take place in a laser rod and the ratio between upper and lower levels in a population inversion state is extremely large as compared with that when the Q switch is off, the Q switch is repeatedly turned on and off at a rate of about several tens kHz to generate light beam pulses, while the Q switch is continuously kept off to generate a CW (continuous wave) laser beam. In the CW mode, the solid-state laser 4 emits a light beam whose energy is low, so that the light beam, if any, irradiated to the to-be-annealed object 2 will not anneal the latter. The "pulse generation" will be referred to as "pulse-on operation" and "CW generation" be referred to as "pulse-off operation" hereunder. That is, the to-be-annealed object 2 will be annealed when the solid-state laser 4 is in the pulse-on mode of operation, and not be annealed during the pulse-off mode of operation.

The light shaping optical system 5 includes a homogenizer and the like. It averages the energy density of a light beam and shapes a section perpendicular to the optical axis of the light beam. The light shaping optical system 5 shapes the section perpendicular to the optical axis of the light beam into a form whose aspect ratio is low. In this embodiment, the light shaping optical system 5 shapes the section perpendicular to the optical axis of the light beam into a rectangular form of $W_x$ = 1.5 (mm) and $W_y$ = 1 (mm).

The reflecting mirror 6 changes the traveling direction of the light beam by reflecting the light beam coming from the light shaping optical system 5. The reflected light beam is incident upon the main surface of the to-be-annealed object 2 through the fθ lens 8. Also, the reflecting mirror 6 is reciprocally moved by the galvanometer 7 at a constant angular velocity within a range of a constant angle of rotation (the reciprocal movement will be referred to as "oscillation" hereunder). The light beam coming from the reflecting mirror 6 is deflected correspondingly to the posture of the reflecting mirror 6. When the reflecting mirror 6 has not been oscillated by the galvanometer 7, the traveling direction of the light beam coming from the light shaping optical system 5 is changed by 90 deg. and thus the light beam is irradiated to the to-be-annealed object 2 from a direction perpendicular to the main surface of the to-be-annealed object 2.

In the following description, a position of the reflecting mirror 6 not oscillated by the galvanometer 7 will be referred to as "reference position" hereunder and a traveling direction of the light beam reflected by the reflecting mirror 6 staying in the home position will be referred to as "reference direction $\phi_0$". Also, an angle $\phi$ of the traveling direction of the light beam reflected by the reflecting mirror 6 in relation to the reference direction $\phi_0$ will be referred to as "angle of deflection: hereunder. It should be noted that the angle of deflection is double an angle of rotation of the reflecting mirror 6. Also, an angle of rotation from the reference position of the reflecting mirror 6 being positioned in a direction counterclockwise rotated from the reference position and an angle of deflection of the light beam reflected by the reflecting mirror 6 in the same position are defined to be "positive" herein, while an angle of rotation from the reference position of the reflecting mirror 6 being positioned in a direction clockwise rotated from the reference position and an angle of deflection of the light beam reflected by the reflecting mirror 6 in the same position are defined to be "negative".

The galvanometer 7 has a rotating shaft 7a on which the reflecting mirror 6 is installed. The galvanometer 7 reciprocally moves the reflecting mirror 6 at a constant angular velocity within in a range of a constant angle of rotation in the direction of arrow H in FIG. 1 (the reciprocal movement will be referred to as "oscillation" hereunder). As the galvanometer 7 oscillates the reflecting mirror 6, the light beam emitted from the solid-state laser 4 is deflected along the direction of arrow A in FIG. 1. As the reflecting mirror 6 is thus oscillated, the light beam emitted from the solid-state laser 4 has the angle of deflection thereof changed periodically within a predetermined range, and the center of a spot 2a defined by the light beam is reciprocally moved on the to-be-annealed object 2 over a predetermined range of dis-

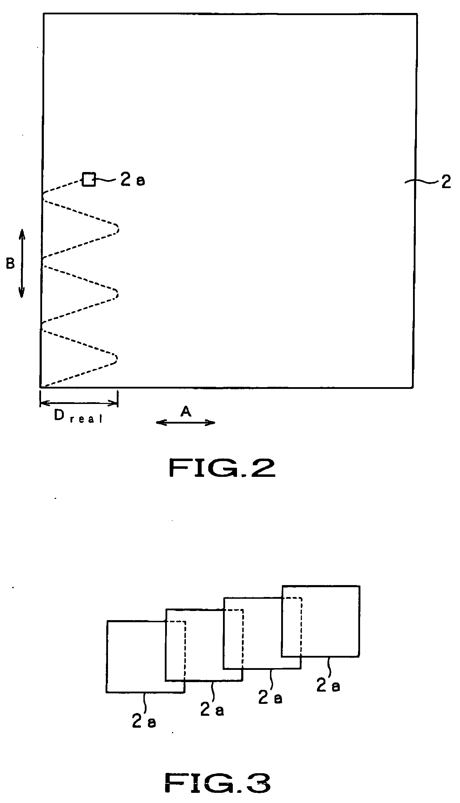

tance $D_{real}$ in a predetermined direction as shown in FIG. 2. The range of distance $D_{real}$ is determined based on a range in which the angle of rotation of the reflecting mirror 6 varies. In this embodiment, the reflecting mirror 6 is reciprocally moved in a range of the angle of deflection thereof from a position of -α (0 < α) to a position of +α. That is, the reciprocally moving range $D_{real}$ of the spot 2a indicates an amplitude of the center of the spot 2a on the to-be-annealed object 2 when the reflecting mirror 6 is reciprocally moved in a range of the angle of deflection thereof from a position of -α (angle of deflection: -2α) to a position of +α (angle of deflection: +2α).

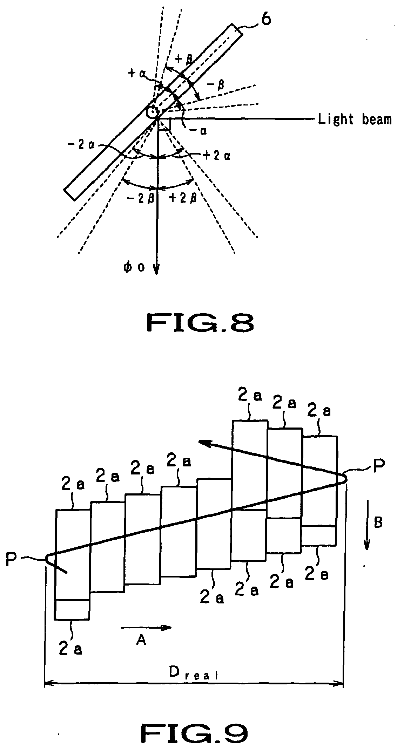

Also, since the galvanometer 7 oscillates the reflecting mirror 6 at a constant velocity and the light beam reflected by the reflecting mirror 6 is irradiated to the to-be-annealed object 2 through the fθ lens 8, the spot 2a on the to-be-annealed object 2 will be moved at a constant velocity. As shown in FIG. 8, since the spot 2a on the to-be-annealed object 2 is moved at the constant velocity, the area where the spot 2a and a spot 2a adjacent to the former spot 2a overlap each other will be constant. That is, it is possible to limit the variation of number of times of light beam irradiation to the to-be-annealed object 2.

For the galvanometer 7 to oscillate the reflecting mirror 6 at a constant velocity, the galvanometer 7 may be applied with a triangular-wave voltage.

Also, by applying a triangular-wave voltage of a frequency as given by the following equation (31) to the galvanometer 7 and irradiating the light beam to the to-be-annealed object 2 while moving the moving stage 3 at a velocity as given by the following equation (32) in the constant-velocity moving direction, it is possible in the laser annealing apparatus 1 to further limit the variation of number of times of light beam irradiation to the to-be-annealed object 2, whereby the to-be-annealed object 2 can be irradiated uniformly with the light beam:

$$f_{galvo} = (F_{rep} \cdot W_x)/(2D) \qquad (31)$$

$$V_{stage} = (F_{rep} \cdot W_x \cdot W_y)/(i \cdot D) \qquad (32)$$

where $F_{rep}$ is a repetition rate at which the solid-state laser 4 generates light beam pulses, $W_x$ is a predetermined-distance moving directional length of the spot 2a defined on the to-be-irradiated object 2, $W_y$ is a constant-velocity moving directional length of the spot 2a defined on the to-be-irradiated object 2, i is a mean number of times of light beam irradiation to the to-be-annealed object 2 within a column, and D is an amplitude of a trajectory of the center of the light beam spot defined on the to-be-irradiated object when the reflecting mirror 6 is ideally oscillated by the galvanometer 7. It should be noted that the "column" will be described in detail later.

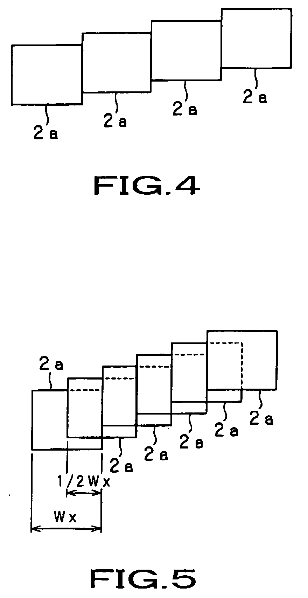

Since the triangular-wave voltage of the frequency $f_{galvo}$ as given by the above equation (31) is applied to the galvanometer 7, the spot 2a and an adjacent spot 2a will not overlap each other as shown in FIG. 4. Also, since the triangular-wave voltage of the frequency $f_{galvo}$ as given by the above equation (33) is applied to the galvanometer 7, the length, in the predetermined-distance moving direction, of a portion where the spot 2a and adjacent spot 2a overlap each other will be $W_x/2$ as shown in FIG. 5.

Also, by applying a triangular-wave voltage of a frequency as given by the following equation (33) to the galvanometer 7 and irradiating the light beam to the to-be-annealed object 2 while moving the moving stage 3 at a velocity as given by the following equation (34) in the constant-velocity moving direction, it is possible in the laser annealing apparatus 1 to further limit the variation of number of times of light beam irradiation to the to-be-annealed object 2, whereby the to-be-annealed object 2 can be irradiated uniformly with the light beam:

$$f_{galvo} = (F_{rep} \cdot W_x)/(4D) \qquad (33)$$

$$V_{stage} = (2 \cdot F_{rep} \cdot W_x \cdot W_y)/(i \cdot D) \qquad (34)$$

The fθ lens 8 is provided on the light path between the reflecting mirror 6 and moving stage 3. When the light beam is irradiated to the to-be-annealed object 2 while the reflecting mirror 6 is oscillated by the galvanometer 7 at a constant angular velocity, the change in angle of rotation of the reflecting mirror 6 is not proportional with a moving distance of the spot 2a on the to-be-annealed object 2 and hence it is difficult to move the spot 2a at a constant velocity However, when the light beam reflected by the reflecting mirror 6 is irradiated to the to-be-annealed object 2 through the fθ lens 8, the change in angle of rotation of the reflecting mirror 6 is proportional with the moving distance of the spot 2a on the to-be-annealed object 2 and thus the spot 2a can be moved at a constant velocity by oscillating the reflecting mirror 6 at a constant angular velocity by the galvanometer 7.

The controller 9 detects an angle of rotation of the reflecting mirror 6 and turns on or off the solid-state laser 4 in generating light beam pulses correspondingly to the detected angle of rotation. The angle of rotation of the reflecting mirror 6 is a half of an angle of deflection of the light beam reflected by the reflecting mirror 6. Therefore, by detecting an angle of rotation of the reflecting mirror 6, it is possible to detect an angle of deflection of the light beam reflected by the reflecting mirror 6. That is, the controller 9 controls the solid-state laser 4 to make the pulse-on or -off operation correspondingly to an angle of deflection of the light beam reflected by the reflecting mirror 6. Also, the controller 9 controls the constant-velocity moving direction and predetermined-distance moving direction of the moving stage 3 by controlling the screw-feeding pulse motor and air-sliding linear motor provided on the moving stage 3.

In the following, there will be explained an angle of rotation of the reflecting mirror 6 when the controller 9 controls the solid-state laser 4 to make the pulse-on or -off operation.

In the laser annealing apparatus 1, the galvanometer 7 is applied with a triangular-wave voltage to oscillate the reflecting mirror 6 at a constant velocity while moving the moving stage 3 at a constant velocity in the constant-velocity moving direction in order to make constant the moving velocity of the spot 2a on the to-be-annealed object 2.

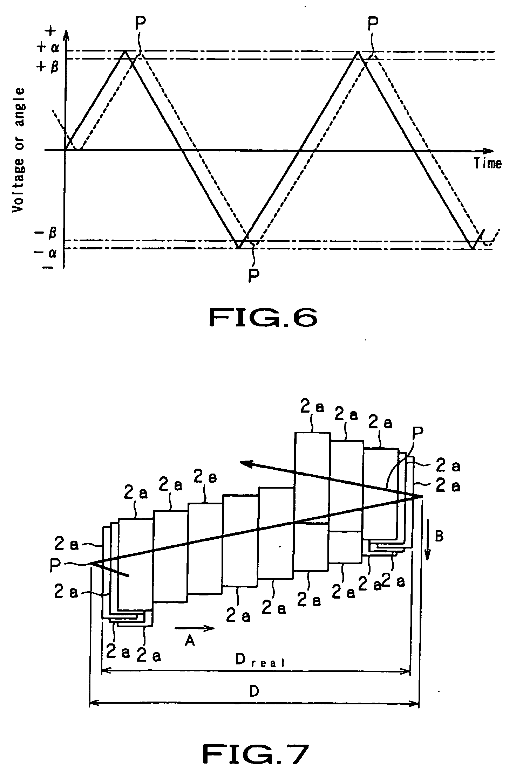

Actually, however, when the rotating direction of the reflecting mirror 6 changes from clockwise to counterclockwise and from counterclockwise to clockwise, an inertia or the like will cause the rotation of the reflecting mirror 6 to slow down when the reflecting mirror 6 has been rotated to near the rotating-direction change point as shown in FIG. 6. It should be noted that the solid line in FIG. 6 indicates a change of the triangular-wave voltage applied to the galvanometer 7, and the broken line in FIG. 6 indicates an angle of rotation of the reflecting mirror 6. The horizontal axis in FIG. 6 indicates a time, and vertical axis indicates an value of the triangular-wave voltage or angle of rotation of the rotating shaft 7a.

When the rotation of the reflecting mirror 6 is dull at a point near the rotating-direction change point, the area in which the spot 2a and a spot 2a adjacent to the former spot 2a in the predetermined-distance moving direction overlap each other will be larger at a point near a point P where the moving direction of the spot 2a on the to-be-annealed object 2 is changed, as will be seen from FIG. 7. Therefore, the number of times of light beam irradiation to the to-be-annealed object 2 will vary from one spot to another. Also, the amplitude of the trajectory of the spot 2a defined on the to-be-annealed object 2 will be $D_{real}$, not D. Since the controller 9 controls the solid-state laser 4 to make the pulse-off operation when the moving-direction change point of the spot 2a is nearly reached, it is possible to reduce the variation of the number of times of light beam irradiation to the to-be-annealed object 2.

More specifically, an angle β (0 < β < α) at which the rotation of the reflecting mirror 6 is dull is determined and the controller 9 controls the solid-state laser 4 to make the pulse-on operation while the reflecting mirror 6 is rotating from + β to - β as shown in FIGS. 6 and 8, whereby it is possible to reduce the variation of the number of times of light beam irradiation to the to-be-annealed object 2.

The controller 9 controls the solid-state laser 4 to make the pulse-on operation as will be described below:

When detecting that the angle of rotation of the reflecting mirror 6 becomes +β after the rotating direction of the reflecting mirror 6 has changed from clockwise to counterclockwise, the controller 9 controls the solid-state laser 4 to make the pulse-on operation. After that, detecting that the angle of rotation of the reflecting mirror 6 becomes -β, the controller 9 controls the solid-state laser 4 to make the pulse-off operation. Also, when detecting that the angle of rotation of the reflecting mirror 6 becomes -β after the rotating direction of the reflecting mirror 6 has changed from counterclockwise to clockwise, the controller 9 controls the solid-state laser 4 to make the pulse-on generation. After that, when detecting that the angle of rotation of the reflecting mirror 6 becomes +β, the controller 9 controls the solid-state laser 4 to make the pulse-off operation. Therefore, when the rotating angle of the reflecting mirror 6 is within a range from +β to -β, that is, when the angle of deflection of the light beam is within a range from +2β to -2β, the light beam is irradiated to the to-be-annealed object 2.

Since the controller 9 controls the pulse-on and -off operations of the laser source (solid-state laser) 4 as above, the spot 2a will not be defined in a position near the moving-direction change point P when the spot is reciprocally moved within the predetermined range $D_{real}$ on the to-be-annealed object 2 as shown in FIG. 9. That is, the region where there is formed a large area in which a spot 2a and another spot 2a adjacent to the former spot 2a in the predetermined-distance moving direction overlap each other will not be formed.

The laser annealing apparatus 1 constructed according to the present invention as above functions as will be described below. It should be noted that the laser annealing apparatus 1 anneals the to-be-annealed object 2 by irradiating the light beam to the entire main surface of the to-be-annealed object 2 n times (n > $0_o$).

When an object to be annealed 2 is placed on the moving stage 3, the galvanometer 7 starts oscillating the reflecting mirror 6 with the frequency as given by the aforementioned equation (31) or (33), thus the light beam emitted from the laser source 4 using the solid-state laser is linearly moved in the predetermined-distance moving direction to move the spot 2a repeatedly within the predetermined range $D_{real}$. Also, as the moving stage 3 is moved at the velocity as given by the aforementioned equation (32) or (34) in the constant-velocity moving direction, the spot 2a is moved at the constant velocity from one end to the other end in the constant-velocity moving direction.

Also, the controller 9 detects an angle of rotation of the reflecting mirror 6 to control the laser source 4 to make the pulse-on or -off operation correspondingly to the detected angle of rotation. More specifically, the controller 9 controls the laser source 4 to make the pulse-on operation when the detected angle of rotation of the rotating mirror 6 is over -β and under +β, and to make the pulse-off operation when the angle is under -β and over +β.

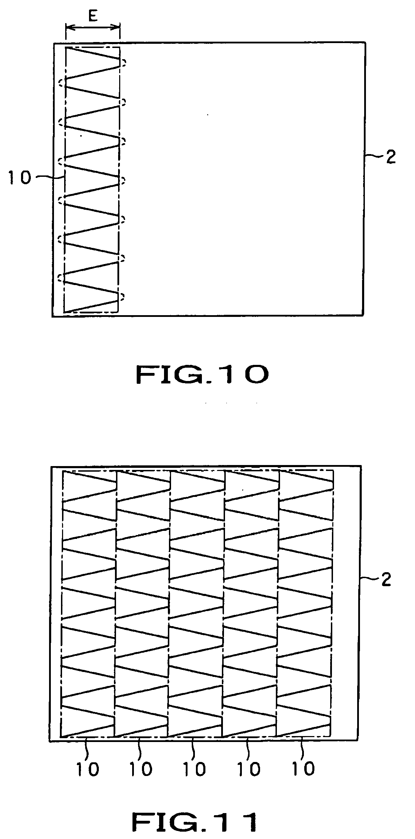

With the aforementioned operations, the trajectory of the spot 2a on the to-be-annealed object 2 will take a form of a triangular wave whose apex has disappeared as shown in FIG. 10. Also, there is formed a light beam-irradiated region (will be referred to as "column" hereunder) 10 having a length E in the predetermined-distance moving direction and whose length in the constant-velocity moving direction is nearly the same as that in the constant-velocity moving direction of the to-be-annealed object 2. It should be noted that the length E is a moving distance of the spot 2a when the reflecting mirror 6 has been rotated from +β to -β with the moving stage 3 not being moved.

Then, the moving stage 3 is moved over a distance of iE/n in the predetermined-distance moving direction after completely moved in the constant-velocity moving direction.

In the laser annealing apparatus 1, the column 10 is formed and the moving stage 3 is moved over a distance of iF/n in the predetermined-distance moving direction, which are alternately done, whereby the spot 2a is moved over the surface of the to-be-annealed object 2 which can thus be annealed as a whole, as shown in FIG. 11. It should be noted that FIG. 11 shows the movement of the spot 2a on the to-be-annealed object 2 when i = n by way of example.

Also in the laser annealing apparatus 1 according to the present invention, even when i is constant for forming the column 10, the mean number n of times of light beam irradiation to the whole surface of the to-be-annealed object 2 can be controlled by controlling the moving distance of the moving stage 3 in the predetermined-distance moving direction.

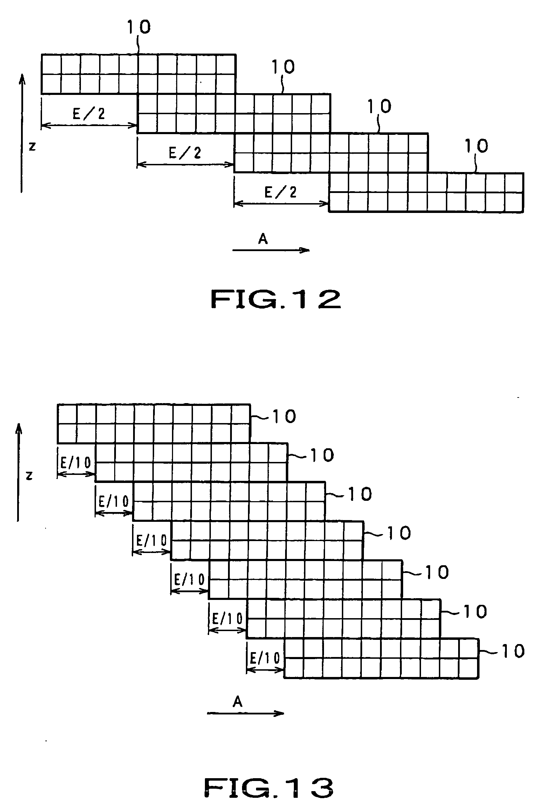

When i = 2, for example, n = 4 is attained by setting the moving distance of the moving stage 3 in the predetermined-distance moving direction to E/2, and by forming the column 10 to be irradiated with the light beam a number of times i = 2 and moving the moving stage 3 over a distance E/2 in the predetermined-distance moving direction alternately as shown in FIG. 12. Also, for n = 10, the moving distance of the moving stage 3 in the predetermined-distance moving direction is set to E/5, and forming the column 10 whose mean number i of times of light beam irradiation is 2 and moving the moving stage 3 over a distance E/5 in the predetermined-distance moving direction are alternately effected as shown in FIG.13. It should be noted that FIGS. 12 and 13 schematically illustrate the relation between a position on the to-be-annealed object 2 in the predetermined-distance moving direction and number of times of light beam irradiation and the number of squares in the direction of arrow z in FIGS. 12 and 13 indicates a number of times of light beam irradiation.

As having been described above, in the laser annealing apparatus 1 according to the present invention, even when the laser source used is a solid-state laser 4 which emits a light beam whose section perpendicular to the optical axis of the light beam should be smaller in aspect ratio because its energy is weak, the variation of the number of times of light beam irradiation to the to-be-annealed object 2 can be reduced and thus the to-be-annealed 2 can be annealed with a sufficient, uniform energy.

In the laser annealing apparatus 1, even if the mean number $\underline{i}$ of times of light beam irradiation to the to-be-annealed object 2 is fixed, the mean number $\underline{n}$ of times of light beam irradiation to the whole surface of the to-be-annealed object 2 can be varied by changing the distance over which the moving stage 3 is moved in the predetermined-distance moving direction. Therefore, in the laser annealing apparatus 1, since the mean number $\underline{i}$ of times of light beam irradiation to the to-be-annealed object 2, one of parameters upon which $V_{stage}$ as given by the equation (32) or (34) depends can be fixed irrespectively of the value of $\underline{n}$, $V_{stage}$ is set to one value when $F_{rep}$, $W_x$ and $W_y$ are values peculiar to the laser annealing apparatus 1. That is, in the laser annealing apparatus 1, it suffices to improve the accuracy and stability of the moving velocity of the moving stage in the constant-velocity moving direction for only the $V_{stage}$ thus set, not for any other $V_{stage}$, so that it is possible to reduce the error of $V_{stage}$. Therefore, in the laser annealing apparatus 1, the moving stage 3 can be moved at a constant velocity with a small variation in the constant-velocity moving direction, and thus the to-be-annealed object 2 can be annealed more uniformly.

As having been described in the foregoing, in the laser annealing apparatus 1, a solid-state laser 4 capable of emitting a light beam whose energy is stable is used as the laser source and the light beam emitted from the solid-state laser 4 is shaped to have a section perpendicular to the optical axis thereof and having a small area, whereby the to-be-annealed object 2 can be irradiated uniformly with the light beam. Therefore, by annealing an amorphous silicon using the laser annealing apparatus 1, it is possible to produce a polysilicon whose grain size is large and uniform and in which electrons and holes are highly movable. A thin film transistor using the polysilicon thus produced will be stable in performance.

Also, since the laser annealing apparatus 1 uses the solid-state laser 4 as the laser source, it has not to be stopped for gas exchange. Therefore, the laser annealing apparatus 1 can anneal a to-be-annealed object 2 with a high efficiency.

Note that a peripheral region of an annealed object 2 will not sufficiently be annealed because the mean number of times of light beam irradiation is less than $\underline{n}$. Normally, however, a peripheral region of several centimeters of the annealed object 2 will not be used. Therefore, by annealing a to-be-annealed object 2 so that such an area not sufficiently annealed will be formed within the peripheral region of several centimeters, the object 2 annealed by the laser annealing apparatus 1 can be used without any problem.

Note here that in the laser annealing apparatus 1, when the moving stage 3 is moved over an incorrect distance in the predetermined-distance moving direction, the area where a column 10 and adjacent column 10 overlap each other (will be referred to as "overlapping area" hereunder) will be different from a desired area.

If the overlapping area is different from the desired area, a region where the overlapping columns 10 count n/i + 1, region where the overlapping columns 10 count n/i - 1 and the like will occur on the to-be-annealed object 2. The region where the overlapping columns 10 count n/i + 1 will be irradiated with the light beam n+i times, and the region where the overlapping columns 10 count n/i -1 will be irradiated with the light beam n-i times. Therefore, when the moving stage 3 is not moved over a correct distance in the predetermined-distance moving direction, the number of times of light beam irradiation to the to-be-annealed object 2 will incur an error of ±i times.

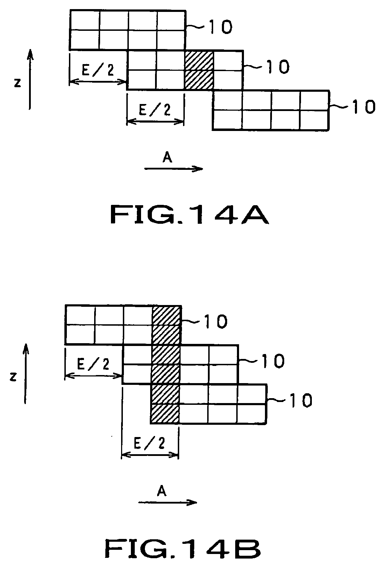

When i = 2 and n = 4, for example, the moving stage 3 will be moved over a distance of E/2 in the predetermined-distance moving direction. If the moving distance of the moving stage 3 in the predetermined-distance moving direction is less than E/2, a region irradiated with the light beam twice will occur on the to-be-annealed object 2 as shown hatched in FIG. 14A. On the other hand, If the moving distance of the moving stage 3 in the predetermined-distance moving direction is more than E/2, a region irradiated with the light beam six times will occur on the to-be-annealed object 2 as shown hatched in FIG. 14B. Therefore, the number of times of light beam irradiation to the to-be-annealed object 2 will incur an error of ±2 times. It should be noted that FIGS. 14A and 14B schematically illustrate the relation between a position on the to-be-annealed object 2 in the predetermined-distance moving direction and number of times of light beam irradiation and the number of squares in the direction of arrow z in FIGS. 14A and 14B indicates a number of times of light beam irradiation.

To reduce the difference in number of times of light beam irradiation to the to-be-annealed object 2 to less than ±i even when the moving stage 3 has been moved over an inaccurate distance in the predetermined-distance moving direction, the position in which the controller 9 controls the solid-state laser 4 to start the pulse-on operation may be made different from the position in which the controller 9 controls the solid-state laser 4 to start the pulse-off operation as will be described below.

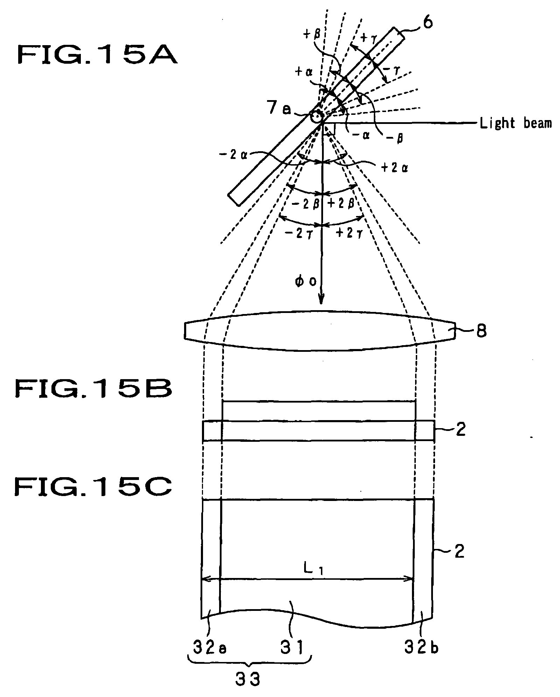

First, the controller determines $\gamma$ ($\gamma < \beta$) as shown in FIGS. 15A to 15C.

Then, when the controller 9 detects that the angle of rotation of the rotating shaft 7a is $+\gamma$ after the rotating direction of the rotating shaft 7a changes from clockwise to counterclockwise, it controls the solid-state laser 4 to make the pulse-on operation, and after that, when it detects that the angle of rotation of the rotating shaft 7a is $-\beta$, it controls the solid-state laser 4 to make the pulse-off operation. Also, when the controller 9 detects that the angle of rotation of the rotating shaft 7a is -γ after the rotating direction of the rotating shaft 7a changes from counterclockwise to clockwise, it controls the solid-state laser 4 to make the pulse-on operation, and then, when it detects that the angle of rotation of the rotating shaft 7a is +β, it controls the solid-state laser 4 to make the pulse-off operation.

Since the controller 9 controls the Q switch of the solid-state laser 4 as above, regions 32a and 32b irradiated with the light beam i/2 times (will be referred to as "i/2 times-irradiated region" hereunder) will be formed at opposite ends, in the predetermined-distance moving direction, of a region 31 irradiated with the light beam i times (will be referred to as "i times-irradiated region" hereunder) as shown in FIGS. 15B and 15C.

The i times-irradiated region 31 has been irradiated with the light beam when the angle of rotation of the rotating shaft 7a is within a range from -2γ to +2γ.

Also, one of the i/2 times-irradiated regions 32a and 32b has been irradiated with the light beam when the angle of rotation of the rotating shaft 7a is within a range from +2γ to +2β, and the other region has been irradiated with the light beam when the angle of rotation of the rotating shaft 7a is within a range from -2β to -2γ.

Then, a range including the i times-irradiated region 31 and one (32a) of the i/2 times-irradiated regions is set as a column 33, and the moving stage 3 is moved in the predetermined-distance moving direction on the basis of a length $L_i$ of the column in the predetermined-distance moving direction. Namely, the moving stage 3 is moved over a distance of $iL_1/n$ in the predetermined-distance moving direction.

When the controller 9 controls the solid-state laser 4 to make the pulse-on or -off operation as above, the moving stage 3 is moved over a distance longer than $iL_1/n$ in the predetermined-distance moving direction, whereby a region where the overlapping columns 33 count n/i + 1 will be irradiated with the light beam n+i/2 times. Further, since the moving stage 3 is moved over a distance shorter than $iL_1/n$, a region where the overlapping columns 33 count i - 1 will be irradiated with the light beam n - i/2 times. Therefore, the error with respect of the number $\underline{n}$ of times of light beam irradiation to the whole to-be-irradiated object 2 can easily be reduced to ±i/2 times.

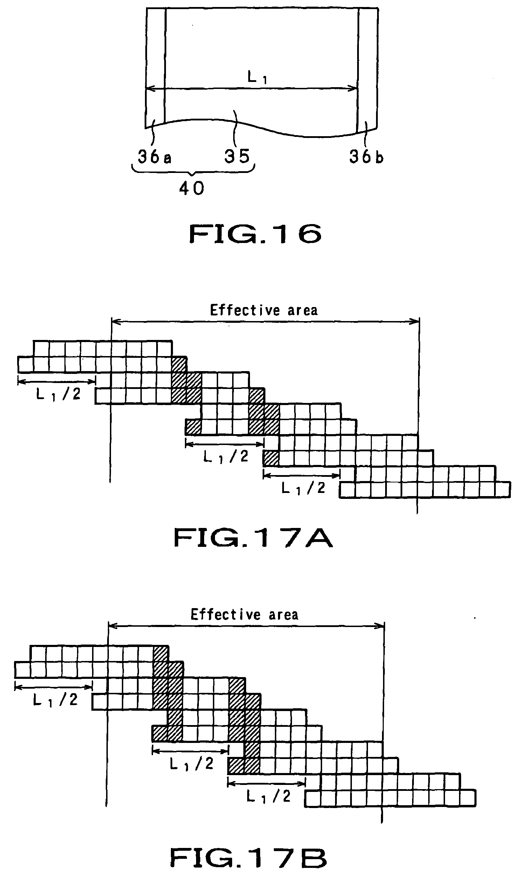

For example, when the triangular-wave voltage to be applied to the galvanometer 7 has a frequency as given by the aforementioned equation (33) and i = 2, regions 36a and 36b irradiated with the light beam once will be formed at opposite ends, in the predetermined-distance moving direction, of a region 35 irradiated twice as shown in FIG. 16. The twice-irradiated region 35 and once-irradiated region 36a are taken as a column 40.

When n = 4, for example, with the above-mentioned conditions, the moving stage 3 is moved over a distance of $L_1/2$ in the predetermined-distance moving direction. When the moving stage 3 is moved over a dis-

tance smaller than $L_1/2$ in the predetermined-distance moving direction, a region irradiated three times will take place on the to-be-annealed object 2 as shown hatched in FIG. 17A. On the other hand, when the moving stage 3 is moved over a distance larger than $L_1/2$, a region irradiated 5 times will occur on the to-be-annealed object 2 as shown hatched in FIG. 17B. Therefore, the error of number of times of light irradiation to the to-be-annealed object 2 will be ±1. It should be noted that FIGS. 17A and 17B schematically illustrate the relation between a position on the to-be-annealed object 2 in the predetermined-distance moving direction and number of times of light beam irradiation and the number of squares in the direction of arrow z in FIGS. 17A and 17B indicate a number of times of light irradiation.

In the laser annealing apparatus 1, the controller 9 can reduce the error in number of times of light beam irradiation to the to-be-annealed object 2 can be reduced to ±1 since the controller 9 controls the solid-state laser 4 to make the pulse-on or -off operation and sets i = 2 as above, thus permitting to reduce the error in number of times of light beam irradiation.

Also, in the laser annealing apparatus 1, by controlling the moving distance of the moving stage 3 in the predetermined-distance moving direction even when i = 2, the number of times of light beam irradiation to the whole main surface of the to-be-annealed object 2 can be changed. When i = 2, the moving stage 3 will be moved over a distance of $2L_1/n$ in the predetermined-distance moving direction. That is, when n = 20, the whole main surface of the to-be-annealed object 2 can be irradiated with the light beam twenty times by moving the moving stage 3 over a distance of $L_1/10$ in the predetermined-distance moving direction.

Therefore, in the laser annealing apparatus 1 according to the present invention, the to-be-annealed object 2 should preferably be annealed with i being 2 (minimum). In the laser annealing apparatus 1, the error in number of times of light beam irradiation to the to-be-annealed object 2 can be limited to ±1 even when the moving stage 3 has been moved over an inaccurate distance in the predetermined-distance moving direction since the controller 9 controls the pulse-on and -off operations and sets i = 2.

Note that γ is determined based on the ratio between the length, in the predetermined-distance moving direction, of the $\underline{i}$ times-irradiated region 31 and those, in the predetermined-distance moving direction, of the i/2 times-irradiated regions 32a and 32b. For example, when the ratio between the length, in the predetermined-distance moving direction, of the $\underline{i}$ times-irradiated region 31 and that, in the predetermined-distance moving direction, of one (32a) of the i/2 times-irradiated regions is R, γ is determined by solving 2β/γ = R.

Note that the pulse-on and -off control by the controller 9 is not limited to the aforementioned one by may be done in any other way. For example, the controller 9 may control the solid-state laser 4 to make the pulse-on operation when it detects that the angle of rotation of the rotating shaft 7a becomes +β after the rotating direction of the rotating shaft 7a has changed from clockwise to counterclockwise, then control the solid-state laser 4 to make the pulse-off operation when it detects that the angle of rotation of the rotating shaft 7a becomes -γ, control the solid-state laser 4 to make the pulse-on operation when it detects that the angle of rotation of the rotating shaft 7a becomes -β after the rotating direction of the rotating shaft 7a has changed from counterclockwise to clockwise, and then control the solid-state laser 4 to make the pulse-off operation when it detects that the angle of rotation of the rotating shaft 7a becomes +γ.

Note here that the aforementioned method of reducing the error in number of times of light beam irradiation to the to-be-annealed object 2 is effective when i is an even number. In the following, there will be explained how the laser annealing apparatus 1 produces columns in which i = 3 and which is capable of reducing the error in number of times of light beam irradiation so that the error in number of times of light beam irradiation to the to-be-annealed object 2 can be reduced even when n is an odd number.

First, the frequency $f_{galvo}$, as given by the following equation (35), of a triangular-wave voltage to be applied to the galvanometer 7 is set to a frequency 2/3 times higher than the frequency as given by the aforementioned equation (31).

$$f_{galvo} = (F_{rep} \cdot W_x)/(3D) \qquad (35)$$

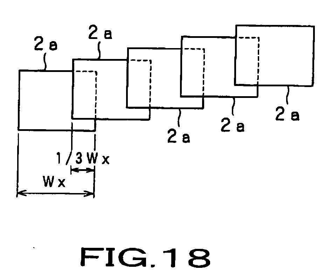

When the frequency $f_{galvo}$ of a triangular-wave voltage to be applied to the galvanometer 7 is set to a frequency as given by the above equation (35), the length, in the predetermined-distance moving direction, of a portion where a spot 2a and adjacent spot 2a overlap each other is $W_x/3$ as shown in FIG. 18.

Also, γ is determined so that the length, in the predetermined-distance moving direction, of a region irradiated with the light beam when the angle of rotation of the rotating mirror 6 is within a range from +γ to +β and that, in the predetermined-distance moving direction, of a region irradiated with the light beam when the angle of rotation of the reflecting mirror 6 is within a range of -β to -γ will be $1/3W_x$.

Further, the moving velocity $V_{stage}$ of the moving stage 3 in the constant-velocity moving direction is set to a velocity as given by the following equation (36):

$$V_{stage} = (F_{rep} \cdot W_x \cdot W_y)/(3D) \qquad (36)$$

Note that the frequency of the triangular-wave voltage to be applied to the galvanometer 7 is provided by correcting the frequency $f_{galvo}$ as given by the equation (31) by multiplying the latter by 2/3. Therefore, the moving velocity $V_{stage}$ of the moving stage 3 in the constant-velocity moving direction is also provided by correcting the moving velocity as give by the aforementioned equation (33), not by placing i = 3 in the equation (33).

When the laser annealing apparatus 1 is put into operation with the frequency $f_{galvo}$ and moving velocity $V_{stage}$ being set as above, the spot 2a is moved from one end to the other end in the predetermined-distance moving direction with the length, in the predetermined-distance moving direction, of a portion where the spot 2a and a spot 2a adjacent spot 2a overlap each other being $W_x/3$ as shown in FIG. 19A, and the spot 2a is moved from one end to the other end in the predetermined-distance moving direction with the length, in the predetermined-distance moving direction, of a portion where the spot 2a and adjacent spot 2a overlap each other being $W_x/3$ as shown in FIG. 19B. These operations are alternately effected.

Then, at one end, in the predetermined-distance moving direction, of a region 51 irradiated with the light beam three times (will be referred to as "three times-irradiated region" hereunder), there are sequentially formed a region 52a irradiated with the light beam two times (will be referred to as "twice-irradiated region" hereunder) and region 53a irradiated with the light beam once (will be referred to as "once-irradiated region" hereunder), and at the other end, in the predetermined-distance moving direction, of the three times-irradiated region 51, there are sequentially formed a twice-irradiated region 52b and one-irradiated region 53b, as shown in FIG. 19C. All the twice-irradiated region 52a, once-irradiated region 53a, twice-irradiated region 52b and once-irradiated region 53b are equal in width to each other.

Next, with the three times-irradiated region 51, one (52a) of the twice-irradiated regions and one (53a) of the once-irradiated regions being taken as a column 60, the moving stage 3 is moved in the predetermined-distance moving direction on the basis of a length $L_2$ of the column 60 in the predetermined-distance moving direction. Namely, the moving stage 3 will be moved over a distance of $iL_2/n$ in the predetermined-distance moving direction.

By forming the column 60 to which the light beam is irradiated a mean number i of times (= 3) in combination with the column 40 to which the light beam is irradiated a mean number i of times (= 2), the number n of times of light beam irradiation can be set to any odd number. However, it is necessary that $L_1 = L_2$.

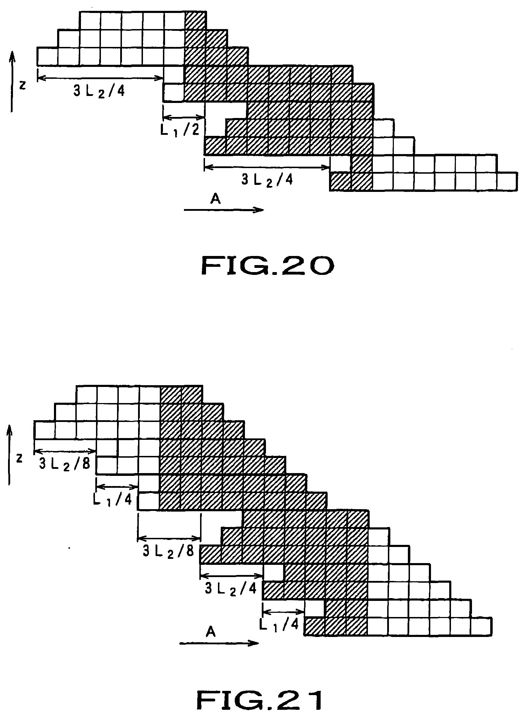

For example, when n = 5, the moving stage 3 is moved over a distance of $3L_2/4$ in the predetermined-distance moving direction after the column 60 is formed, and the moving stage 3 is moved over a distance of $L_1/4$ in the predetermined-distance moving direction after the column 40 is formed. These operations are alternately effected as shown in FIG. 20.

Also, when n = 7, the moving stage 3 is moved over a distance of $3L_2/8$ in the predetermined-distance moving direction after a column 60 is formed, which is a first step, the moving stage 3 is moved over a distance of $L_1/4$ in the predetermined-distance moving direction after a column 40 is formed, as a second step, and the moving stage 3 is moved over a distance of $3L_1/8$ in the predetermined-distance moving direction after a column 40 is formed, which is a third step, as shown in FIG. 21. Then, the first, second and third steps are repeated sequentially.

As having been described in the foregoing, when the moving stage 3 is moved over a distance shorter than desired in the predetermined-distance moving direction and an area of overlapping between adjacent columns is increased even when $\underline{n}$ is an odd number because the column 60 to be irradiated with the light beam i times (i = 3) is formed, the error in number of times of light beam irradiation is +1. When the moving stage 3 is moved over a distance shorter than desired in the predetermined-distance moving direction and an area of overlapping between adjacent columns is decreased in the above condition, the error in number of times of light beam irradiation is -1.

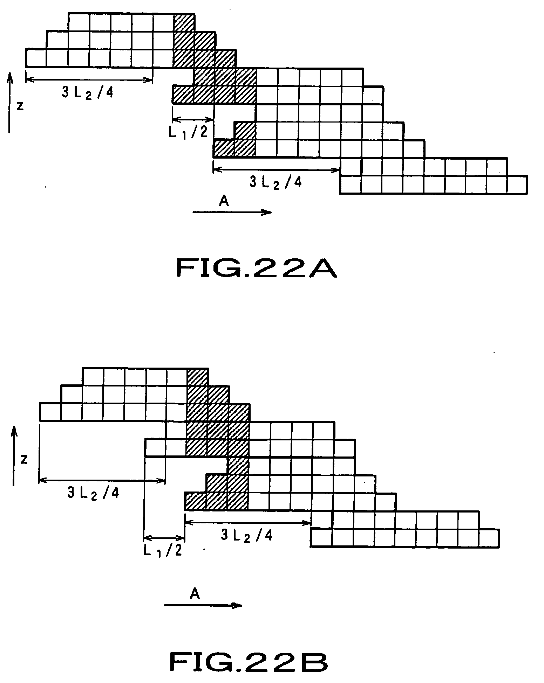

For example, when n = 5 is set in the method shown in FIG. 20, a region to be irradiated with the light beam four times will take place as shown hatched in FIG. 22A if the moving stage 3 is moved over a distance shorter than $3L_2/4$ in the predetermined-distance moving direction after the column 60 is formed. On the other hand, if the moving stage 3 is moved over a distance longer than $3L_2/4$ in the predetermined-distance moving direction, a region to be irradiated with the light beam six times will occur as shown hatched in FIG. 22B. Therefore, the error in number of times of light beam irradiation is $\pm 1$.

That is, by forming the column 60 to be irradiated i times (i = 3) as above, it is possible to reduced the error in number of times of light beam irradiation to the to-be-annealed object 2 to $\pm 1$ even when the number $\underline{n}$ of times of light irradiation to the to-be-annealed object 2 is an odd number.

Note that FIGS. 20, 21 and 22 schematically illustrate the relation between a position on the to-be-annealed object 2 in the predetermined-distance moving direction and number of times of light beam irradiation and the number of squares in the direction of arrow z in FIGS. 20 to 22 indicates a number of times of light beam irradiation.

In the foregoing, the present invention has been described in detail concerning certain preferred embodiments thereof as examples with reference to the accompanying drawings. However, it should be understood by those ordinarily skilled in the art that the present invention is not limited to the embodiments but can be modified in various manners, constructed alternatively or embodied in various other forms without departing from the scope and spirit thereof as set forth and defined in the appended claims.

Industrial Applicability

As having been described in the foregoing, according to the present invention, it is possible to reduce the variation of number of times of light beam irradiation to a to-be-irradiated object even when the to-be-irradiated is irradiated with a light beam whose section perpendicular to the optical axis thereof is smaller in aspect ratio because its energy is weak. Therefore, in the light irradiating apparatus according to the present invention, a solid-state laser to emit a light beam which is weak in energy but stable can be used as the laser source and the to-be-irradiated object can be irradiated with a sufficient, uniform energy.

Also, according to the present invention, even when a region of irradiation formed through a first control is to be irradiated with a light beam fixed number of times, the number of times of light beam irradiation to the to-be-irradiated object can be controlled by controlling the moving distance of the moving stage in a second control. Therefore, since one of parameters on which the moving velocity of the moving stage in a first direction depends can be fixed, the error in moving velocity for moving the moving stage in the first direction can be reduced. That is, in the light irradiating apparatus according to the present invention, the variation of number of times of light beam irradiation to the to-be-irradiated object can be reduced.

Therefore, by annealing an amorphous silicon using the laser annealing apparatus 1, it is possible to produce a polysilicon whose grain size is large and uniform and in which electrons and holes are highly movable. A thin film transistor using the polysilicon thus produced will be stable in performance.

**Claims**

1. A light irradiating apparatus comprising:

   a laser source to emit a light beam;
   a stage to support a flat to-be-irradiated object;
   an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object;
   a light beam emission controlling means for controlling the light beam emission from the laser source correspondingly to the angle of deflection of the light beam;
   a first controlling means for irradiating the light beam, of which the emission has been controlled by the light beam emission controlling means, to the main surface of the to-be-irradiated object while scanning the light beam in the first direction, and moving the stage in relation to the irradiating means in a second direction perpendicular to the first direction along the main surface of the to-be-irradiated object; and a second controlling means for controlling the stage, once moved by the first controlling means, to move in relation to the irradiating means in the first direction,

the light beam irradiation controlled by the first controlling means being made to the same to-be-irradiated surface of the to-be-irradiated object in each of a plurality of different positions along the first direction, reached under the control of the second controlling means, and almost all the to-be-irradiated surfaces of the to-be-irradiated object undergoing the light beam irradiation controlled by the first controlling means in each of the different positions.

2. The apparatus according to claim 1, wherein the laser source generates light beam pulses.

3. The apparatus according to claim 1, wherein the light beam emission controlling means operates alternately in a first control mode in which it controls the laser source to start generation of light beam pulses when the angle of deflection becomes $\theta_a$ after taking a first extreme value and to stop generation of light beam pulses when the angle of deflection becomes $\theta_b$ after that, and in a second control mode in which it controls the laser source to start generation of light beam pulses when the angle of deflection becomes $\theta_c$ after taking a first extreme value and to stop generation of light beam pulses when the angle of deflection becomes $\theta_d$ after that.

4. The apparatus according to claim 3, wherein the angles of deflection $\theta_a$ and $\theta_d$ are equal to each other and the angles of deflection $\theta_b$ and $\theta_c$.

5. The apparatus according to claim 3, wherein the angle of deflection $\theta_a$ is a value closer to the first extreme value than the angle of deflection $\theta_d$ and the angle of deflection $\theta_c$ is a value closer to the second extreme value than the angle of deflection $\theta_b$.

6. The apparatus according to claim 5, wherein the deflecting means deflects the light beam at a frequency $f_{galvo}$ as given by the following equation (1) and the moving stage moves at a velocity $V_{stage}$ as given by the following equation (2) in the first direction:

$$f_{galvo} = (F_{rep} \cdot W_x)/(2D) \qquad (1)$$

$$V_{stage} = (F_{rep} \cdot W_x \cdot W_y)/(2D) \qquad (2)$$

where $F_{rep}$ is a repetition rate at which the laser source generates light beam pulses, $W_x$ is a first-directional length of a spot defined on the to-be-irradiated object, $W_y$ is a second-directional length of the spot defined on the to-be-irradiated object, and D is an amplitude of a trajectory of the center of the light beam spot defined on the to-be-irradiated object when the light beam emitted from the laser source is ideally deflected.

7. The apparatus according to claim 5, wherein:

the light beam emission controlling means makes a first-directional length of a first irradiation area defined by the irradiated light beam whose angle of deflection ranges from $\theta_a$ to $\theta_b$ coincide with a first-directional length of a second region of irradiation defined by the irradiated light beam whose angle of deflection ranges from $\theta_c$ to $\theta_d$ and sets the length of a first-directional displacement between the first and second irradiation areas to $W_x/3$; and
the deflecting means deflects the light beam at a frequency $f_{galvo}$ as given by the following equation (3) and the moving stage moves at a velocity $V_{stage}$ as given by the following equation (4) in the first direction:

$$f_{galvo} = (F_{rep} \cdot W_x)/(3D) \qquad (3)$$

$$V_{stage} = (F_{rep} \cdot W_x \cdot W_y)/(3D) \qquad (4)$$

8. The apparatus according to claim 3, wherein the angle of deflection $\theta_d$ is a value closer to the first extreme value than the angle of deflection $\theta_a$ and the angle of deflection $\theta_b$ is a value closer to the second extreme value than the angle of deflection $\theta_c$.

9. The apparatus according to claim 8, wherein the deflecting means deflects the light beam at a frequency $f_{galvo}$ as given by the following equation (5) and the moving stage moves at a velocity $V_{stage}$ as given by the following equation (6) in the first direction:

$$f_{galvo} = (F_{rep} \cdot W_x)/(2D) \qquad (5)$$

$$V_{stage} = (F_{rep} \cdot W_x \cdot W_y)/(2D) \qquad (6)$$

**10.** The apparatus according to claim 8, wherein:

the light beam emission controlling means makes a first-directional length of a first irradiation area defined by the irradiated light beam whose angle of deflection ranges from $\theta_a$ to $\theta_b$ coincide with a first-directional length of a second region of irradiation defined by the irradiated light beam whose angle of deflection ranges from $\theta_c$ to $\theta_d$ and sets the length of a first-directional displacement between the first and second irradiation areas to $W_x/3$; and
the deflecting means deflects the light beam at a frequency $f_{galvo}$ as given by the following equation (7) and the moving stage moves at a velocity $V_{stage}$ as given by the following equation (8) in the first direction:

$$f_{galvo} = (F_{rep} \cdot W_x)/(3D) \qquad (7)$$

$$V_{stage} = (F_{rep} \cdot W_x \cdot W_y)/(3D) \qquad (8)$$

**11.** The apparatus according to claim 1, wherein the deflecting means is a galvanometer.

**12.** The apparatus according to claim 1, wherein the first controlling means includes a linear motor to move the stage in relation to the to-be-irradiated object in the second direction.

**13.** The apparatus according to claim 1, wherein the second controlling means includes a pulse motor to move the stage in relation to the to-be-irradiated object in the first direction.

**14.** The apparatus according to claim 1, wherein the laser source is a solid-state laser.

**15.** A light irradiating apparatus comprising:

a laser source to emit a light beam;
a moving stage which supports a flat to-be-irradiated object and moves the to-be-irradiated object in a direction parallel with the main surface of the to-be-irradiated object;
an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object; and
a light beam emission controlling means for controlling the light beam emission from the laser source correspondingly to the angle of deflection of the light beam.

**16.** A light irradiating apparatus comprising:

a laser source to emit a light beam;
a moving stage to support a flat to-be-irradiated object;
an irradiating means including a deflecting means for deflecting an incident light beam while changing the angle of deflection periodically in a constant range, and which guides the light beam emitted from the laser source and irradiates the light beam to the main surface of the to-be-irradiated object while scanning the light beam in a first direction along the main surface of the to-be-irradiated object;
a first controlling means for irradiating the light beam, of which the emission has been controlled by a light beam emission controlling means, to the main surface of the to-be-irradiated object while scanning the light beam in the first direction, and moving the stage in relation to the irradiating means in a second direction perpendicular to the first direction along the main surface of the to-be-irradiated object; and
a second controlling means for controlling the stage, once moved by the first controlling means, to move in relation to the irradiating means in the first direction,
the light beam irradiation controlled by the first controlling means being made to the same to-be-irradiated surface of the to-be-irradiated object in each of a plurality of different positions along the first direction, reached under the control of the second controlling means, and almost all the to-be-irradiated surfaces of the to-be-irradiated object undergoing the light beam irradiation controlled by the first controlling means in each of the different positions.

**17.** A light irradiating method comprising:

a light beam emitting step in which a laser source emits a light beam;
an irradiating step including a deflecting step of deflecting an incident light beam while changing the angle of deflection periodically in a constant range, and in which the light beam emitted from the laser source is guided and irradiated the light beam to the main surface of the to-be-irradiated object while the light beam is being scanned in a first direction along the main surface of the to-be-irradiated object;
a light beam emission controlling step of controlling the light beam emission from the laser source correspondingly to the angle of deflection of the light beam;

a first controlling step of irradiating the light beam, of which the emission has been controlled in the light beam emission controlling step, to the main surface of the to-be-irradiated object while scanning the light beam in the first direction, and moving the to-be-irradiated object in relation to the light beam, having been irradiated to the main surface of the to-be-irradiated object in the irradiating step, in a second direction perpendicular to the first direction along the main surface of the to-be-irradiated object; and

a second controlling step of moving the to-be-irradiated object, once moved in the first controlling step, in relation to the light beam irradiated to the main surface in the irradiating step, the light beam irradiation controlled in the first controlling step being made to the same to-be-irradiated surface of the to-be-irradiated object in each of a plurality of different positions along the first direction, reached in the second controlling step, and almost all the to-be-irradiated surfaces of the to-be-irradiated object undergoing the light beam irradiation controlled in the first controlling step in each of the different positions.

18. The method according to claim 17, wherein in the light beam emitting step, the laser source generates light beam pulses.

19. The method according to claim 18, wherein in the light beam emission controlling step, there are alternately effected a first control mode in which the laser source is controlled to start generation of light beam pulses when the angle of deflection becomes $\theta_a$ after taking a first extreme value and to stop generation of light beam pulses when the angle of deflection becomes $\theta_b$ after that, and a second control mode in which the laser source is controlled to start generation of light beam pulses when the angle of deflection becomes $\theta_c$ after taking a second extreme value and to stop generation of light beam pulses when the angle of deflection becomes $\theta_d$ after that.

20. The method according to claim 19, wherein the angles of deflection $\theta_a$ and $\theta_d$ are equal to each other and the angles of deflection $\theta_b$ and $\theta_c$.

21. The method according to claim 19, wherein the angle of deflection $\theta_a$ is a value closer to the first extreme value than the angle of deflection $\theta_d$ and the angle of deflection $\theta_c$ is a value closer to the second extreme value than the angle of deflection $\theta_d$.

22. The method according to claim 19, wherein the an-

gle of deflection $\theta_d$ is a value closer to the first extreme value than the angle of deflection $\theta_a$ and the angle of deflection $\theta_c$ is a value closer to the second extreme value than the angle of deflection $\theta_b$.

23. A light irradiating method comprising:

a light beam emitting step in which a laser source emits a light beam;

a moving step of moving a flat to-be-irradiated object in a direction parallel with the main surface of the to-be-irradiated object;

an irradiating step including a deflecting step of deflecting an incident light beam while changing the angle of deflection periodically in a constant range, and in which the light beam emitted from the laser source is guided and irradiated to the main surface of the to-be-irradiated object while the light beam is being scanned in a first direction along the main surface of the to-be-irradiated object; and

a light beam emission controlling step of controlling the light beam emission from the laser source correspondingly to the angle of deflection of the light beam.

24. A light irradiating method comprising:

a light beam emitting step in which a laser source emits a light beam;

an irradiating step including a deflecting step of deflecting an incident light beam while changing the angle of deflection periodically in a constant range, and in which the light beam emitted from the laser source is guided and irradiated to the main surface of the to-be-irradiated object while the light beam is being scanned in a first direction along the main surface of the to-be-irradiated object;

a first controlling step of irradiating the light beam controlled in the light beam emission controlling step to the main surface of the to-be-irradiated object while scanning the light beam in the first direction, and moving the to-be-irradiated object in relation to the light beam irradiated to the main surface of the to-be-irradiated object in the irradiating step in a second direction perpendicular to the first direction along the main surface of the to-be-irradiated object; and

a second controlling step of moving the to-be-irradiated object, once moved in the first controlling step, in relation to the light beam irradiated to the main surface of the to-be-irradiated object in the irradiating step, the light beam irradiation controlled in the first controlling step being made to the same to-be-irradiated surface of the to-be-irradiated object

**EP 1 566 834 A1**

in each of a plurality of different positions along the first direction, reached in the second controlling step, and almost all the to-be-irradiated surfaces of the to-be-irradiated object undergoing the light beam irradiation controlled in the first controlling step in each of the different positions.

FIG.1

2 a

2

B

$D_{real}$

A

FIG.2

2 a    2 a    2 a    2 a

FIG.3

FIG.4

FIG.5

FIG.6

FIG.7

**FIG.8**

**FIG.9**

FIG.10

FIG.11

## FIG.12

## FIG.13

FIG.14A

FIG.14B

FIG.15A

FIG.15B

FIG.15C

## FIG.16

## FIG.17A

## FIG.17B

FIG.18

FIG.19A

FIG.19B

FIG.19C

1/3 Wx

1/3 Wx

2a

2a

2a

2a

B

A

2a

2a

2a

B

2a

A

L₂

B

53a 52a 51

A

52b 53b

60

FIG.20

FIG.21

FIG.22A

FIG.22B

FIG.23

## INTERNATIONAL SEARCH REPORT

| | International application No. |
|---|---|
| | PCT/JP03/13647 |

**A. CLASSIFICATION OF SUBJECT MATTER**
Int.Cl⁷ H01L21/268, H01L21/20

According to International Patent Classification (IPC) or to both national classification and IPC

**B. FIELDS SEARCHED**

Minimum documentation searched (classification system followed by classification symbols)
Int.Cl⁷ H01L21/26-21/268, H01L21/322-21/326, H01L21/20

Documentation searched other than minimum documentation to the extent that such documents are included in the fields searched
Jitsuyo Shinan Koho        1922-1996    Toroku Jitsuyo Shinan Koho    1994-2003
Kokai Jitsuyo Shinan Koho  1971-2003    Jitsuyo Shinan Toroku Koho    1996-2003

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 9-7968 A (Mitsubishi Electric Corp.), 10 January, 1997 (10.01.97), | 1,11-13, 15-17,23,24 |
| Y | Full text; Figs. 1 to 18 (Family: none) | 2-10,14, 18-22 |
| Y | JP 2002-176006 A (Sumitomo Heavy Industries, Ltd.), 21 June, 2002 (21.06.02), Full text; Figs. 1 to 17 (Family: none) | 2-10,14, 8-22 |
| P,X | JP 2003-45820 A (Semiconductor Energy Laboratory Co., Ltd.), 14 February, 2003 (14.02.03), Full text; Figs. 1 to 16 (Family: none) | 1-24 |

|☒| Further documents are listed in the continuation of Box C. |☐| See patent family annex. |
|---|---|---|---|

* Special categories of cited documents:
"A"  document defining the general state of the art which is not considered to be of particular relevance
"E"  earlier document but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| 24 December, 2003 (24.12.03) | 20 January, 2004 (20.01.04) |

| Name and mailing address of the ISA/ Japanese Patent Office | Authorized officer |
|---|---|
| Facsimile No. | Telephone No. |

Form PCT/ISA/210 (second sheet) (July 1998)

**EP 1 566 834 A1**

## INTERNATIONAL SEARCH REPORT

| | International application No. |
|---|---|
| | PCT/JP03/13647 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-50583 A  (Sony Corp.),<br>15 February, 2002 (15.02.02),<br>Full text; Figs. 1 to 3<br>(Family: none) | 1-24 |

Form PCT/ISA/210 (continuation of second sheet) (July 1998)